# EUROPEAN PATENT APPLICATION

(11) **EP 4 718 159 A1**
(43) Date of publication of application: **01.04.2026**
(21) Application number: 24203638.2
(22) Date of filing: 30.09.2024
(51) Int. Cl.: G03F 9/00, H01L 21/683, G03F 7/00

(54) **SUBSTRATE DEVICE**

(71) Applicant: ASML Netherlands B.V., 5500 AH Veldhoven (NL)
(72) Inventor: AUSSEMS, Damien, Uriël, Boaz, 5500 AH Veldhoven (NL); KOEVOETS, Adrianus, Hendrik, 5500 AH Veldhoven (NL)
(74) Representative: ASML Netherlands B.V.

(57) **Abstract**

A substrate device for being held by an electrostatic clamp, the substrate device having a bottom side configured to face a substrate support surface of the clamp in use, the substrate device comprising a plasma generating part configured to form a plasma space between a first portion of the bottom side and an associated first portion of the substrate support surface of the clamp, wherein the plasma generating part is configured to generate a plasma within the plasma space, and a connection part electrically connected to the plasma generating part and configured to provide an electrically conductive connection between one or more substrate conductors provided on a second portion of the bottom side and one or more clamp conductors on the clamp during use.

## Description

### FIELD

The present invention relates to a substrate device for being held by an electrostatic clamp and to a combination of the substrate device and the electrostatic clamp. The present invention further relates to a system comprising the combination and a power source, and to a lithographic apparatus comprising the system. The present invention yet further relates to a method for cleaning a substrate support surface, preferably clamp burls, of an electrostatic clamp.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

During the lithographic process the substrate, or wafer, is supported and clamped on a wafer support surface of an electrostatic wafer clamp. The wafer support surface may be formed by a plurality of wafer clamp burls. Over time the wafer support surface experiences chemical and particle contaminations. These contaminations have a negative effect on the functioning of the electrostatic wafer clamp, and thereby on the lithographic apparatus. Similarly, an electrostatic patterning device clamp may be subject to contamination.

### SUMMARY

It is an object of the invention to provide a device and method for cleaning the substrate support surface of an electrostatic clamp.

According to a first aspect of the invention, there is provided a substrate device for being held by an electrostatic clamp, the substrate device having a bottom side configured to face a substrate support surface of the electrostatic clamp in use, the substrate device comprising:
- a plasma generating part configured to form a plasma space between a first portion of the bottom side and an associated first portion of the substrate support surface of the clamp during use, wherein the plasma generating part is configured to generate a plasma within the plasma space,
- a connection part electrically connected to the plasma generating part and configured to provide an electrically conductive connection between one or more substrate conductors provided on a second portion of the bottom side and one or more clamp conductors on an associated second portion of the substrate support surface of the clamp during use.

According to a second aspect of the invention, there is provided a combination of an electrostatic clamp and a substrate device according to the first aspect, the substrate device configured to be supported on the electrostatic clamp during use.

According to a third aspect of the invention, there is provided a system comprising a combination, according to the second aspect, of an electrostatic clamp and a substrate device supported on the electrostatic clamp, and a power source configured to power the substrate device by providing electrical power to the one or more clamp conductors of the electrostatic clamp.

According to a fourth aspect of the invention, there is provided a lithographic apparatus comprising said system according to the third aspect.

According to a fifth aspect of the invention, there is provided a method for cleaning a substrate support surface, preferably clamp burls, of an electrostatic clamp, the method comprising the steps of:
a) providing a combination, according to the second aspect, of an electrostatic clamp and a substrate device supported on the electrostatic clamp,
b) powering the connection part of the substrate device with the clamp, thereby powering the plasma generating part of the substrate device via the connection part,
c) generating plasma within the plasma space defined between the plasma generating part of the substrate device and an associated first portion of the substrate support surface, wherein the plasma cleans the electrostatic clamp located adjacent the plasma generating part.

### BRIEF DESCRIPTION OF THE DRAWINGS

Embodiments of the invention will now be described, by way of example only, with reference to the accompanying schematic drawings in which like reference symbols designate like parts, in which.
- Figure 1 depicts a lithographic system comprising a lithographic apparatus and a radiation source;
- Figure 2 schematically depicts a cross-sectional side view of an embodiment of a system according to the invention comprising an embodiment of a combination according to the invention comprising an electrostatic wafer clamp and an embodiment of a substrate device according to the invention.
- Figure 3 schematically depicts, in cross-sectional side view, an embodiment of a substrate device according to the invention.
- Figure 4 schematically depicts, in cross-sectional side view, another embodiment of a substrate device according to the invention.
- Figure 5 (A) schematically depicts a detail A of figure 2 for the embodiment of the substrate device as shown in figure 3.
- Figure 6 (A) schematically depicts a detail A of figure 2 for the embodiment of the substrate device as shown in figure 4.
- Figure 7 schematically depicts a top view of an electrostatic clamp comprising a plurality of burls, wherein a substrate device is schematically depicted by a circle with dashed line.
- Figure 8 schematically depicts a top view of cross-section B as shown in figure 4.

### DETAILED DESCRIPTION

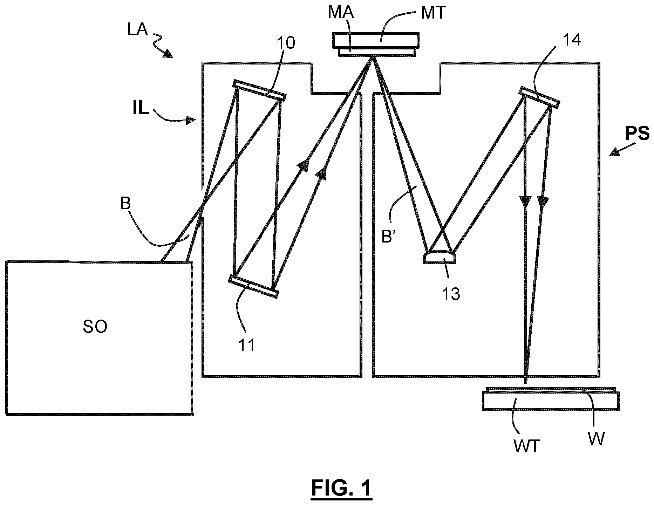

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT which comprises an electrostatic clamp. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

In embodiments of the present invention, the substrate device is a wafer device and the electrostatic clamp is an electrostatic wafer clamp.

Although the below description of examples relate to a wafer device and a wafer clamp, similar examples apply to embodiments of the present invention wherein the substrate device is a patterning device device and the electrostatic clamp is an electrostatic patterning device clamp. In this regard it is mentioned that by the bottom side of the substrate device, it is merely mentioned that this is the side configured to face the electrostatic clamp during use, irrespective of the orientation of the substrate device.

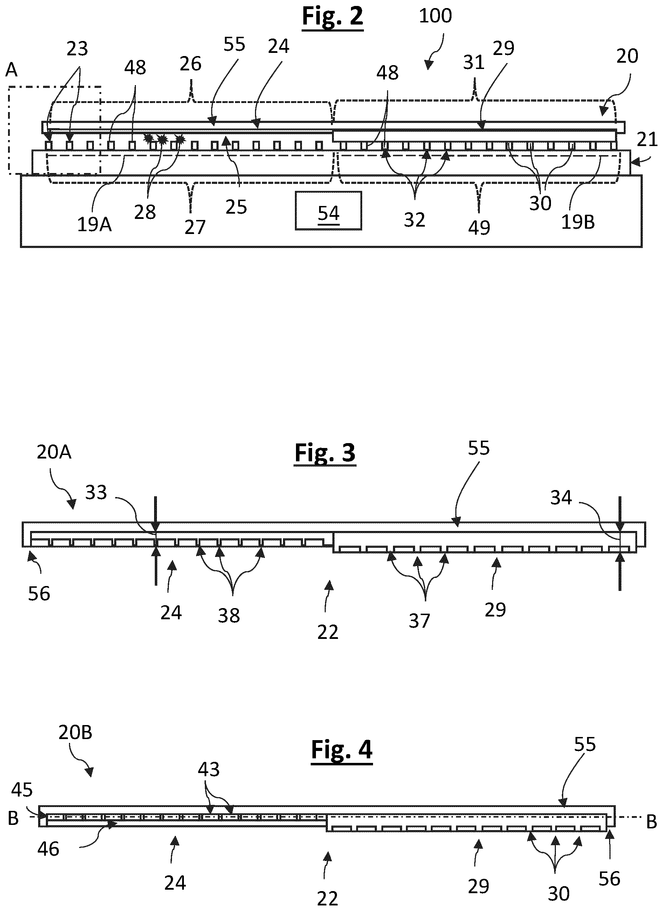

Turning to figure 2, an embodiment is shown of a combination 100 of an electrostatic clamp, in the present example being a wafer clamp 21, and an embodiment of a substrate device according to the present invention, in the present example being a wafer device 20 that is being supported, and held, or clamped, by the electrostatic wafer clamp 21. The combination 100 is part of a system further comprising a power source 54 configured to power the wafer device 20 by providing electrical power to one or more clamp conductors of the electrostatic wafer clamp 21. The electrostatic wafer clamp 21 is part of the earlier mentioned substrate table WT. The wafer device 20 has a bottom side 22 that faces a wafer support surface 23 of the wafer clamp.

The electrostatic wafer clamp 21 has a plurality of burls 48 on an upper surface thereof, for supporting a wafer during use. The mentioned one or more clamp conductors 32 of the electrostatic wafer clamp 21 are formed by burls 48 being made of a conductive material or at least by top surface layers thereof being of a conductive material. The plurality of wafer clamp burls 48 form the wafer support surface 23 with respective top surfaces 52 thereof. Wafer clamp burls 48 (or the top surface layers thereof) are, at least in the present example, interconnected via conductive lines that may be referred to as `Manhattan lines' (not shown) and which may be electrically connected to a power source at least for the purpose of the present disclosure.

The wafer device 20, also indicated in the figures by numerals 20A and 20B to indicate different examples, comprises, see also figures 3 and 4, a plasma generating part 24 configured to form a plasma space 25 between a first portion 26 of the bottom side 22 and an associated first portion 27 of the wafer support surface 23 of the wafer clamp. The plasma generating part 24 is configured to generate a plasma 28 within the plasma space 25. The generated plasma 28 may effectively reduce the amount of contaminations on the part of the wafer clamp comprising the associated first portion 27 of wafer support surface 23. That means, the generated plasma may effectively reduce the amount of contamination on and between the burls associated with the associated first portion 27 of the wafer support surface.

The wafer device 20 is intended to be used for periodic cleaning of the top side, so of the wafer support surface 23 including any areas between the burls, of the wafer clamp facing a wafer in normal use such as during exposure or inspection, for example. The wafer device 20 may therefore be used a number of times.

An advantage of the wafer device 20 is that it allows for in situ cleaning of the electrostatic clamp.

The wafer device 20 comprises a connection part 29 that is electrically connected to the plasma generating part 24. The connection part 29 is configured to provide an electrically conductive connection between one or more wafer conductors 30 provided on a second portion 31 of the bottom side 22 and one or more clamp conductors 32 on an associated second portion of the wafer support surface of the wafer clamp during use.

The plasma generating part 24 of the wafer device 20 extends over an associated first portion 27 of the wafer clamp burls 48 without contacting the wafer clamp burls 48. The first portion 26 of the wafer device 20 for example covers a first half of the wafer clamp burls 48. The first portion 27 of the wafer clamp burls 48 are interconnected by first conductive lines (not shown). The first conductive lines, and thereby the burls 48 associated with the first portion 27 of the burls, are electrically connected to the mentioned power source.

The wafer conductors 30 of the second portion 31 of the wafer device 20 are in contact with an associated second portion 49 of the wafer clamp burls 48. The second portion 31 of the wafer device for example covers a remaining, second half of the wafer clamp burls 48. The associated second portion 49 of the wafer clamp burls 48 are interconnected by second conductive lines (not shown), electrically isolated from the first conductive lines. The second conductive lines, and thereby the burls 48 associated with the second portion 49 of the burls, are electrically connected to the mentioned power source. The power source may be configured to individually power the first or second portion of the wafer clamp burls 48, dependent on which portion is in contact with the connection part 29 of the substrate device.

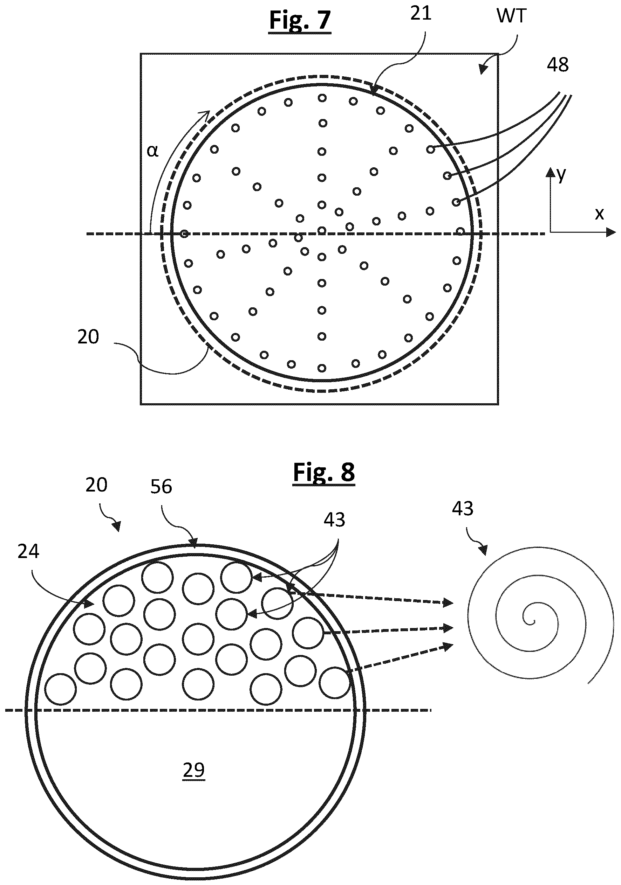

Equally dividing the first portion 26 and second portion 31 as two halves, i.e. a first portion surface area covered by the first portion 26 is substantially equal to a second portion surface area covered by the second portion 31, as schematically shown in the embodiment of figure 8, may provide an efficient way of powering the wafer device 20. Further, cleaning all burls may be efficiently done in just two stages using the wafer device 20, i.e. once for the first half of the wafer clamp burls 48 and once for the second half of the wafer clamp burls 48 after rotating the wafer device 20 relative to the wafer clamp over 180 degrees in direction α (figure 7).

The wafer device 20 is plate shaped and may have overall dimensions similar to that of a production wafer. The plasma generating part 24 has a first thickness 33. The connection part 29 has a second thickness 34. The second thickness 34 is greater than the first thickness 33. The wafer device is designed, in the present example by the mentioned difference in thickness, such that when the wafer device 20 is supported on the wafer clamp during use, the first portion 26 of the bottom side 22 is free from, here the associated first portion 27 of, the water support surface, while the second portion 31 is in contact with, here the second associated portion of, the wafer support surface 23.

The wafer device 20 comprises, at least in the present example, a wafer support structure 55 to which the plasma generating part 24 and connection part 29 are connected. The wafer support structure may be made of a crystalline silicon and comprises a circumferential edge 56 extending around and enclosing the plasma generating part 24 and connection part 29.

The one or more wafer conductors 30 comprise a plurality of connection protrusions 37. One or more connection protrusions 37 are configured to contact one or more clamp conductors 32 of the wafer clamp during use. Preferably all connection protrusions 37 are configured to contact clamp conductors 32 of the wafer clamp during use, for example when there are the same number of or fewer connection protrusions 37 than clamp conductors 32.

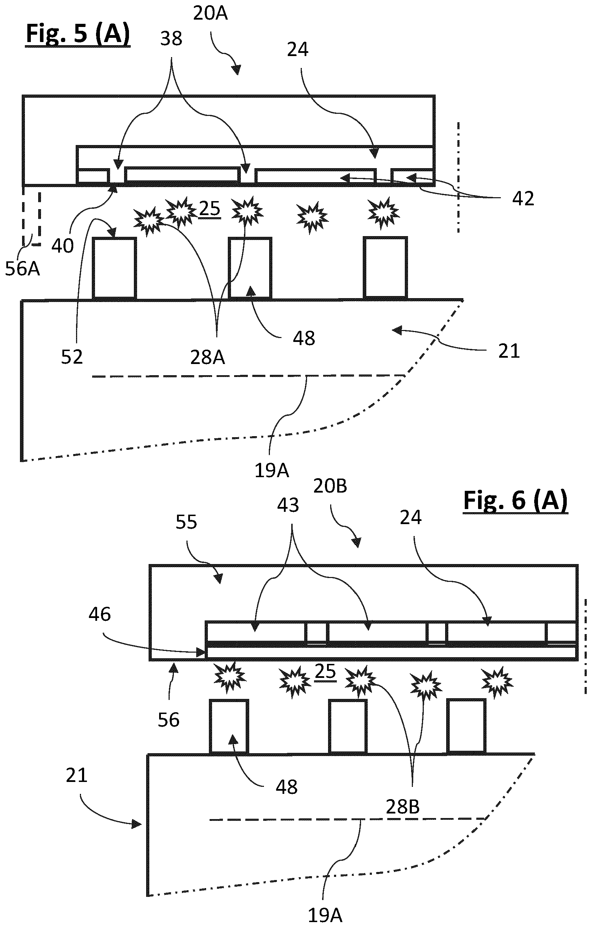

The wafer clamp has, at least in the present example, two embedded electrodes indicated by the dashed lines 19A and 19B in figure 2, which electrodes serve to electrostatically clamp a wafer, or in accordance with the present disclosure a substrate device, to the wafer clamp. Alternatively, the clamp may have one, or may have more electrodes. Also, such one or more electrodes may alternatively be provided in an electrode sheet provided in between the burls, for example. Such electrostatic clamping allows for an increase in gas pressure in the plasma space or at least reduces the likelihood that the wafer device is lifted by such increased gas pressure. The system according to the invention may, for the purpose of providing gas in the plasma space, comprise a gas delivery system, and may provide a gas, for example hydrogen gas, to the plasma space during use. Such gas delivery system is typically present for example in the lithograph apparatus as described above, for providing so called backfill gas between the wafer clamp and a wafer during normal use. The gas is typically provided via passages though the electrostatic clamp and may flow outwards to the periphery of the clamp. The mentioned circumferential edge may optionally have a flow-restricting protrusion, for example as shown as the cylinder-shaped extension portion 56A in figure 5 (A), extending from the bottom side of the substrate device and configured to form a restriction of outflow of gas from the plasma space.

Turning to figures 3 and 5 (A), an embodiment of the wafer device 20A is shown, wherein the plasma generating part 24 comprises a plurality of plasma generating protrusions 38 configured as electrode to generate direct-current plasma 28A within the plasma space 25. The plasma generating protrusions 38 project from a conductive layer, e.g. a metal layer comprising for example chromium nitride or titanium nitride. The plasma generating protrusions 38 are powered via the connection part 29, which connection part 29 is powered by the clamp conductors 32.

The plasma generating protrusions 38 have a protrusion end surface 40 having a protrusion end surface area. The protrusion end surface area may be 400 µm² or less. The protrusion end surface area may be chosen in dependence on properties of the wafer clamp burls 48 of the wafer clamp to be cleaned.

The wafer clamp burls 48 have a burl end surface 52 having a burl end surface area. For the purpose of cleaning a certain type of wafer clamp, the respective protrusion end surfaces 40 of the plasma generating protrusions 38 may be designed and positioned such that they each face a burl end surface 52. In other words the protrusion end surfaces 40 are in that case located directly above and overlay burl end surfaces 52. A ratio of the burl end surface area to the protrusion end surface area may be 100:1 or higher. By having such a ratio most of the voltage does not fall over the wafer clamp burls 48, but over the wafer device 20A, thereby reducing the ion energy at the wafer clamp burls 48. When powered in direct current mode the defined surface area ratio results in plasma equilibrium where the high ion energy, which is needed to pump the plasma, is directed to the wafer device 20A. This way the wafer device 20A is damaged instead of the wafer clamp burls 48.

The plasma generating protrusions 38 may have a protrusion height of between 10-300 µm.

The wafer device 20A may comprise an isolation layer 42 at the first portion 26 of the bottom side 22, wherein the plurality of plasma generating protrusions 38 extend through the isolation layer 42.

Figures 4, 6(A) and 8 show another embodiment of a wafer device 20B, wherein the plasma generating part 24 comprises at least one planar spiral coil 43 for generating inductively coupled plasma 28B within the plasma space 25. The at least one planar spiral coil 43 functions as radio frequency antenna. The at least one planar spiral coil 43 is powered via the connection part 29, which connection part 29 is powered by the clamp conductors 32.

The plasma generating part 24 comprises a coil layer 45 comprising the at least one planar spiral coil 43, and a quartz window layer 46. The quartz window layer 46 is located between the coil layer 45 and the wafer support surface 23 during use. The at least one planer spiral coil 43 serves as a radiofrequency antenna which transfers the radiofrequency power across the quartz window layer 46 to generate and sustain the discharge below. A radiofrequency matching network may be used for optimizing the power coupled into the plasma.

A plurality of planar spiral coils 43 may be distributed across the coil layer 45 in segments, as for example schematically shown in the cross-section through the coil layer 45 in figure 8. The planar spiral coils 43 may also be designed per dimension of the wafer clamp burls 48. Exemplary dimensions of the spirals may be 1,5 mm diameter with 1-3 windings up to 1 cm with for example 5-10 windings. The cross-section area of the coil 'wires' is generally dimensioned on the basis of the required current to be carried. The planar spiral coils may for example be made with lithography, for example conventional lithography processing.

During use of the combination 100 the wafer support surface 23 of the electrostatic wafer clamp 21 is cleaned. The connection part 29 of the wafer device 20B is powered with the electrostatic wafer clamp 21, here via the clamp conductors 32. The electrostatic wafer clamp 21 is powered by a power source. The connection part 29 in turn powers the plasma generating part 24 of the wafer device 20B. The powered plasma generating part 24 generates plasma 28 within the plasma space 25 defined between the plasma generating part 24 of the wafer device 20B and an associated first portion 27 of the wafer support surface 23. The plasma 28 cleans the surface part of the electrostatic wafer clamp located under the plasma generating part, such as the associated first portion 27 of the wafer support surface 23.

In case an embodiment of the wafer device 20A such as shown in figure 3 is used, i.e. comprising a plurality of plasma generating protrusions 38, the cleaning comprises generating direct-current plasma 28A within the plasma space 25 via the plurality of plasma generating protrusions 38.

In case an embodiment of the wafer device 20B such as shown in figure 4 is used, i.e. comprising at least one planar spiral coil 43, the cleaning comprises generating inductively coupled plasma 28B within the plasma space 25 via the at least one planar spiral coil 43.

With the wafer device 20 and method according to the invention damage to the wafer support surface 23 by high ion energy may be reduced. The etch yield may be reduced, causing the sputtering to be below the ion sputtering threshold. This subsequently may reduce surface roughening, which impacts friction/Wafer Load Grid. It also may prevent or at least reduce flatness issues due to etching, and prevent or at least reduce trapping energy drift, which impact cycle induced charging. Due to less sputtering, less material or particles are created which can end up on the wafer clamp or even outside the wafer clamp. Issues related to contamination, e.g. defect driven local charge or wafer stage sensor drifts, may thereby be reduced.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

A number of aspects of the present disclosure are defined in the following numbered paragraphs:
1. A substrate device for being held by an electrostatic clamp, the substrate device having a bottom side configured to face a substrate support surface of the clamp in use, the substrate device comprising:
   - a plasma generating part configured to form a plasma space between a first portion of the bottom side and an associated first portion of the substrate support surface of the clamp during use, wherein the plasma generating part is configured to generate a plasma within the plasma space,
   - a connection part electrically connected to the plasma generating part and configured to provide an electrically conductive connection between one or more substrate conductors provided on a second portion of the bottom side and one or more clamp conductors on an associated second portion of the substrate support surface of the clamp during use.
2. Substrate device according to clause 1, wherein the substrate device is a wafer device for being held by an electrostatic wafer clamp.
3. Substrate device according to clause 1 or 2, wherein the substrate device is plate shaped, wherein the plasma generating part has a first thickness, and wherein the connection part has a second, greater thickness, such that when the substrate device is supported on the clamp during use, the first portion of the bottom side is free from the water support surface.
4. Substrate device according to any one of the preceding clauses, wherein a first portion surface area of the first portion of the bottom side is substantially equal to a second portion surface area of the second portion of the bottom side.
5. Substrate device according to any one of the preceding clauses, wherein the one or more substrate conductors comprise a plurality of connection protrusions, wherein one or more connection protrusions are configured to contact one or more clamp conductors of the clamp during use, wherein preferably all connection protrusions are configured to contact clamp conductors of the clamp during use.
6. Substrate device according to any one of the preceding clauses, wherein the plasma generating part comprises a plurality of plasma generating protrusions configured as electrode to generate direct-current plasma within the plasma space.
7. Substrate device according to the preceding clause, wherein the plasma generating protrusions have a protrusion end surface having a protrusion end surface area, the protrusion end surface area being 400 µm² or less.
8. Substrate device according to clause 6 or 7, comprising an isolation layer at the first portion of the bottom side, wherein the plurality of plasma generating protrusions extend through the isolation layer.
9. Substrate device according to according to any one of the preceding clauses, wherein the plasma generating part comprises at least one planar spiral coil for generating inductively coupled plasma within the plasma space, the at least one planar spiral coil functioning as radio frequency antenna.
10. Substrate device according to the preceding clause, wherein the plasma generating part comprises a coil layer comprising the at least one planar spiral coil, and a quartz window layer, the quartz window layer being located between the coil layer and the substrate support surface during use.
11. Substrate device according to any one of the preceding clauses, comprising a substrate support structure to which the plasma generating part and connection part are connected.
12. Substrate device according to the preceding clause, wherein the substrate support structure comprises a circumferential edge extending around and enclosing the plasma generating part and preferably also the connection part.
13. Combination of an electrostatic clamp and a substrate device according to any one of the preceding clauses, the substrate device configured to be supported on the electrostatic clamp during use.
14. Combination according to the preceding clause, wherein the one or more clamp conductors of the electrostatic clamp comprise a plurality of clamp burls, the plurality of clamp burls forming a substrate support surface,
   wherein the plasma generating part of the substrate device extends over an associated first portion of the clamp burls without contacting the clamp burls, and
   wherein the substrate conductors of the substrate device are in contact with an associated second portion of the clamp burls.
15. Combination according to clause 13 or 14, wherein the first portion covers a first half of the clamp burls, and wherein the second portion covers a remaining, second half of the clamp burls.
16. Combination according to clause 13, comprising the substrate device according to clause 6, wherein the clamp burls have a burl end surface having a burl end surface area, wherein the protrusion end surface and the burl end surface face each other, wherein the ratio of the burl end surface area to the protrusion end surface area is 100: 1 or higher.
17. System comprising a combination according to any one of clauses 12-15, and a power source configured to power the substrate device by providing electrical power to the one or more clamp conductors of the electrostatic clamp.
18. Lithographic apparatus comprising a system according to the preceding clause.
19. Method for cleaning an electrostatic clamp, the method comprising the steps of:
   a) providing a combination according to clause 13 or a clause dependent thereof,
   b) powering the connection part of the substrate device with the clamp, thereby powering the plasma generating part of the substrate device via the connection part,
   c) generating plasma within the plasma space defined between the plasma generating part of the substrate device and an associated first portion of the substrate support surface, wherein the plasma cleans the electrostatic clamp located adjacent the plasma generating part.
20. Method according to the preceding clause, wherein the plasma generating part comprises a plurality of protrusions, wherein the protrusions are located directly above and overlay the second portion of clamp burls, wherein the protrusions have a protrusion end surface having a protrusion end surface area, and wherein the clamp burls have a burl end surface having a burl end surface area, wherein the protrusion end surface and the burl end surface face each other, wherein the ratio of the burl end surface area over the protrusion end surface area is 100: 1 or higher, wherein step c) comprises generating direct-current plasma within the plasma space via the plurality of plasma generating protrusions.
21. Method according to clause 19, wherein the plasma generating part comprises at least one planar spiral coil, wherein step c) comprises generating inductively coupled plasma within the plasma space via the at least one planar spiral coil.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A substrate device for being held by an electrostatic clamp, the substrate device having a bottom side configured to face a substrate support surface of the clamp in use, the substrate device comprising:
• a plasma generating part configured to form a plasma space between a first portion of the bottom side and an associated first portion of the substrate support surface of the clamp during use, wherein the plasma generating part is configured to generate a plasma within the plasma space,
• a connection part electrically connected to the plasma generating part and configured to provide an electrically conductive connection between one or more substrate conductors provided on a second portion of the bottom side and one or more clamp conductors on an associated second portion of the substrate support surface of the clamp during use.

2. Substrate device according to claim 1, wherein the substrate device is plate shaped,
wherein the plasma generating part has a first thickness, and wherein the connection part has a second, greater thickness, such that when the substrate device is supported on the clamp during use, the first portion of the bottom side is free from the water support surface.

3. Substrate device according to claim 1 or 2, wherein a first portion surface area of the first portion of the bottom side is substantially equal to a second portion surface area of the second portion of the bottom side.

4. Substrate device according to any one of the preceding claims, wherein the one or more substrate conductors comprise a plurality of connection protrusions, wherein one or more connection protrusions are configured to contact one or more clamp conductors of the clamp during use, wherein preferably all connection protrusions are configured to contact clamp conductors of the clamp during use.

5. Substrate device according to any one of the preceding claims, wherein the plasma generating part comprises a plurality of plasma generating protrusions configured as electrode to generate direct-current plasma within the plasma space, preferably wherein the plasma generating protrusions have a protrusion end surface having a protrusion end surface area, the protrusion end surface area being 400 µm² or less.

6. Substrate device according to claim 5, comprising an isolation layer at the first portion of the bottom side, wherein the plurality of plasma generating protrusions extend through the isolation layer.

7. Substrate device according to according to any one of the preceding claims, wherein the plasma generating part comprises at least one planar spiral coil for generating inductively coupled plasma within the plasma space, the at least one planar spiral coil functioning as radio frequency antenna, preferably wherein the plasma generating part comprises a coil layer comprising the at least one planar spiral coil, and a quartz window layer, the quartz window layer being located between the coil layer and the substrate support surface during use.

8. Substrate device according to any one of the preceding claims, comprising a substrate support structure to which the plasma generating part and connection part are connected, preferably wherein the substrate support structure comprises a circumferential edge extending around and enclosing the plasma generating part and preferably also the connection part.

9. Combination of an electrostatic clamp and a substrate device according to any one of the preceding claims, the substrate device configured to be supported on the electrostatic clamp during use.

10. Combination according to the preceding claim, wherein the one or more clamp conductors of the electrostatic clamp comprise a plurality of clamp burls, the plurality of clamp burls forming a substrate support surface,
wherein the plasma generating part of the substrate device extends over an associated first portion of the clamp burls without contacting the clamp burls, and wherein the substrate conductors of the substrate device are in contact with an associated second portion of the clamp burls.

11. Combination according to claim 9 or 10, comprising the substrate device according to claim 5, wherein the clamp burls have a burl end surface having a burl end surface area, wherein the protrusion end surface and the burl end surface face each other, wherein the ratio of the burl end surface area to the protrusion end surface area is 100: 1 or higher.

12. System comprising a combination according to any one of claims 9-11, and a power source configured to power the substrate device by providing electrical power to the one or more clamp conductors of the electrostatic clamp.

13. Lithographic apparatus comprising a system according to the preceding claim.

14. Method for cleaning an electrostatic clamp, the method comprising the steps of:
d) providing a combination according to claim 9 or a claim dependent thereof,
e) powering the connection part of the substrate device with the clamp, thereby powering the plasma generating part of the substrate device via the connection part,
f) generating plasma within the plasma space defined between the plasma generating part of the substrate device and an associated first portion of the substrate support surface, wherein the plasma cleans the electrostatic clamp located adjacent the plasma generating part.

15. Method according to the preceding claim, wherein
- the plasma generating part comprises a plurality of protrusions, wherein the protrusions are located directly above and overlay the second portion of clamp burls, wherein the protrusions have a protrusion end surface having a protrusion end surface area, and wherein the clamp burls have a burl end surface having a burl end surface area, wherein the protrusion end surface and the burl end surface face each other, wherein the ratio of the burl end surface area over the protrusion end surface area is 100: 1 or higher, wherein step c) comprises generating direct-current plasma within the plasma space via the plurality of plasma generating protrusions,
or,
- wherein the plasma generating part comprises at least one planar spiral coil, wherein step c) comprises generating inductively coupled plasma within the plasma space via the at least one planar spiral coil.
